# EUROPEAN PATENT SPECIFICATION

(11) **EP 3 676 655 B1**
(45) Date of publication and mention of the grant of the patent: **21.01.2026**
(21) Application number: 18849783.8
(22) Date of filing: 28.08.2018
(51) Int. Cl.: G02B 27/09, G03B 21/20, H01S 5/42

(54) **STRUCTURED LIGHT PROJECTION**
PROJEKTION VON STRUKTURIERTEM LICHT
PROJECTION DE LUMIÈRE STRUCTURÉE

(30) Priority: 28.08.2017 US 201762551012 P
(43) Date of publication of application: 08.07.2020
(73) Proprietor: ams-OSRAM Asia Pacific Pte. Ltd., Singapore 569877 (SG)
(72) Inventor: ROSSI, Markus, Singapore 738317 (SG)
(74) Representative: Viering, Jentschura & Partner mbB Patent- und Rechtsanwälte
(86) International application number: PCT/SG2018/050433
(87) International publication number: WO 2019/045645

(56) References cited:
- CN-A- 106 569 382
- CN-A- 106 990 660
- CN-A- 106 990 660
- CN-A- 107 026 392
- CN-A- 107 026 392
- CN-A- 107 063 124
- US-A1- 2013 038 881
- US-A1- 2016 377 414

## Description

### FIELD OF THE DISCLOSURE

The present disclosure relates to structured light projection system, and a method of projecting an irregular structured light pattern onto an object.

### BACKGROUND

Examples of optoelectronic modules are disclosed in US 2013 / 038881 A1, CN 106 990 660 A, and CN 107 026 392 A.

Various imaging applications use compact optoelectronic modules that can be integrated, for example, within host computing devices such as smart phones, tablets, laptops or personal computers. In some applications, the module includes a light source to project a structured light pattern onto a scene that includes one or more objects of interest. In some structured-light assemblies, a pattern is projected onto a subject, an image of the pattern is obtained, the projected pattern is compared to the collected pattern, and differences between the two patterns are correlated with depth information. Thus, distortions in the pattern are correlated with depth. Such techniques can be useful for low-light and low-texture objects or scenes because the structured light can provide additional texture (e.g., for matching pixels in the stereo images).

### SUMMARY

The present disclosure describes techniques for creating an irregular structured light pattern using a regular array of light emitting elements. The invention is set out in the appended set of claims.

For example, the disclosure describes a method of creating an irregular structured light pattern from a regular array of light emitting elements. The method includes generating a regular pattern of light from a uniformly distributed array of light emitting elements, altering the regular pattern of light to generate an irregular pattern of light, and reproducing the irregular pattern of light in multiple instances arranged adjacent one another.

One or more of the following features are present in some implementations. For example, the array of light emitting elements can include columns and rows of light emitting elements, wherein the rows are arranged perpendicularly relative to the columns or wherein the rows are angled relative to the columns. In some implementations, the array of light emitting elements produces a regular pattern of a sub pattern of lights. In some cases, the array of light emitting elements produces a grid of a cluster of lights, wherein the grid has commonly shaped clusters in a first direction, and wherein the grid has differently shaped clusters in a second direction perpendicular to the first direction.

In some implementations, the method included receiving light emitted from the array of light emitting elements and projecting the light to a first diffractive optical element to generate the irregular pattern of light. The irregular pattern of light may be, for example, at least one of a randomized, non-uniform, non-grid, disrupted, unevenly spaced, partially obstructed, partially blocked, and/or non-equally distributed pattern.

In some cases, reproducing the irregular pattern in multiple instances includes producing a uniform distribution of the irregular pattern. Reproducing the irregular pattern of light may include producing a tiled pattern, producing multiple interlaced instances of the irregular pattern of light, and/or producing multiple partially overlapping instances of the irregular pattern of light.

This disclosure also describes a structured light projection system that includes an array of light emitting elements operable, collectively, to emit a regular pattern of light. The system further includes a first optical element configured to alter the pattern of light emitted by the array of light emitting elements to generate a first irregular pattern of light, and a second optical element configured to receive the irregular pattern of light generated by the first optical element and to produce a pattern comprising multiple instances of the first irregular pattern.

One or more of the following features are present in some implementations. For example, the array of light emitting elements can include columns and rows of light emitting elements, wherein the rows are arranged perpendicularly relative to the columns or wherein the rows are angled relative to columns. In some cases, the array of light emitting elements is operable to project a regular pattern of a sub pattern of lights. In some implementations, the array of light emitting elements is operable to project a grid of a cluster of lights, wherein the grid has commonly shaped clusters in a first direction, and wherein the grid has differently shaped clusters in a second direction perpendicular to the first direction. The light emitting elements can be, for example, VCSELs.

The first irregular pattern of light can be, for example, at least one of a randomized, nonuniform, non-grid, disrupted, unevenly spaced, partially obstructed, partially blocked, and/or non-equally distributed pattern.

The structured light projection system can further include a projection lens system operable to receive light emitted from the array of light emitting elements and to project the light to the first optical element. The second optical element can be arranged to produce a uniform distribution of the irregular pattern, a tiled pattern, multiple interlaced instances of the irregular pattern of light, and/or multiple partially overlapping instances of the irregular pattern of light.

In some implementations, each of the first and second optical elements comprises a diffractive optical element.

The present disclosure also describes an optical sensor module that includes an optical source including a structured light projection system operable to project a structured light pattern onto an object. The module also includes an optical sensor to sense light reflected back from the object illuminated by the structured light pattern, and processing circuitry operable to determine a physical characteristic of the object based at least in part on a signal from the optical sensor. The disclosure also describes a host device (e.g., a smartphone) that includes the optical sensor module, wherein the host device is operable to use data obtained by the optical sensor of the optical sensor module for one or more functions executed by the host device.

Various advantages can be achieved in some implementations. For example, the disclosed subject matter can facilitate producing structured light patterns that can enhance three - dimensional imaging or other systems and may be used to enhance the operation of smartphones and other computing devices that incorporate a structured light projection system as described here.

Other aspects, features and advantages will be readily apparent from the following detailed description, the accompanying drawings and the claims.

### BRIEF DESCRIPTION OF THE DRAWINGS

FIG. 1 illustrates an example of a structured light projection system.
FIGS. 2, 3, 4, 5 and 6 illustrate examples of arrays of light emitting elements arranged in a regular pattern.
FIG. 7 illustrates an example of a structured light projection system of arranged to produce a tiled light pattern.
FIG. 8 illustrates an example of a structured light projection system of arranged to produce an interlaced light pattern.
FIG. 9 illustrates an example of a projection lens system.
FIG. 10 illustrates an example of a diffractive optical element.
FIG. 11 illustrates an example of a module that incorporated a structured light projection system.
FIG. 12 illustrates an example of a host device that incorporates a structured light projection system.

### DETAILED DESCRIPTION

The present disclosure describes techniques for creating an irregular structured light pattern using a regular array of light emitting elements. As described in greater detail below, a method can include generating a regular pattern of light from a regular array of light emitting elements (e.g., a uniformly distributed array of vertical-cavity surface-emitting lasers (VCSELs)). The regular pattern of light can be, for example, a uniformly distributed pattern, a grid-like pattern, or other regular pattern. The method includes altering the regular pattern of light emitted to generate an irregular representation of light, and reproducing the irregular representation of light as multiple instances arranged adjacent one another.

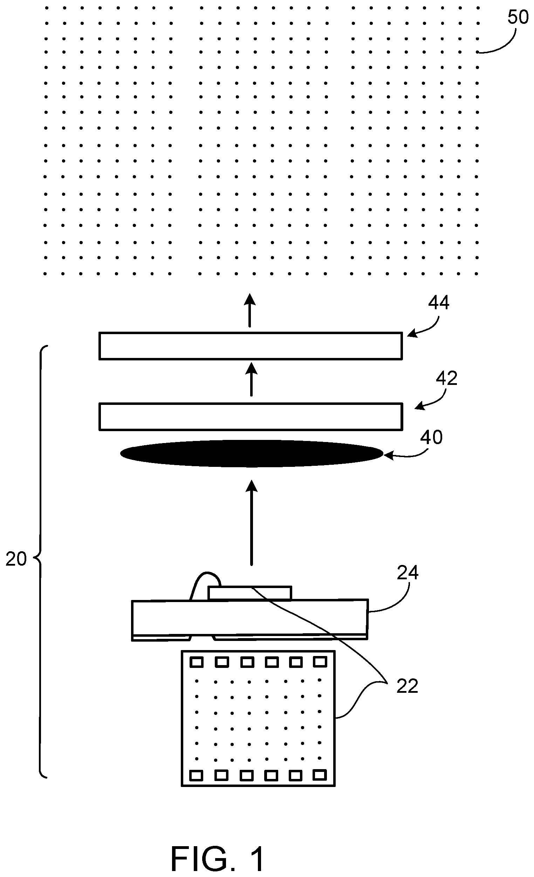

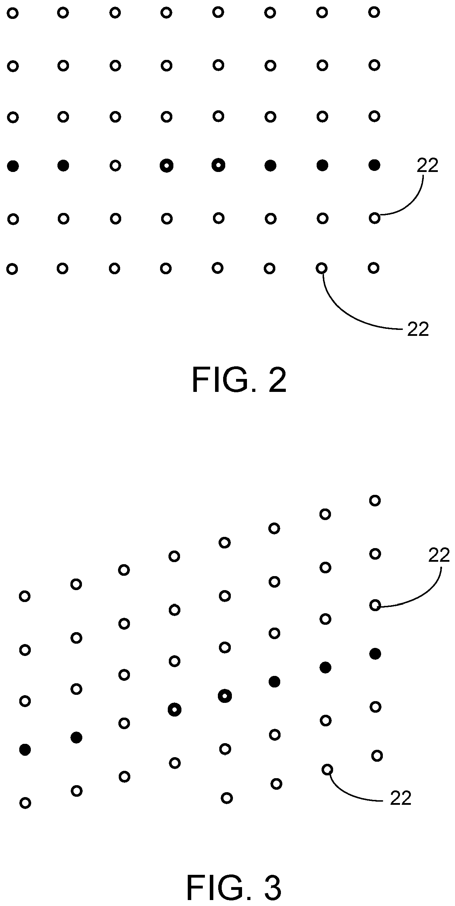

FIG. 1 illustrates an example of a structured light projection system 20 in accordance with some implementations. The system is operable to carry out various methods described in this disclosure. As shown in FIG. 1, the system 20 includes an array of light emitting elements such as VCSELs 22, which can be mounted, for example, on a substrate in a module 24. The VCSELs 22 can be arranged in a regular pattern. FIGS. 2 and 3 illustrate examples of regular patterns of the VCSELs. In particular, FIGS. 2 and 3 depict examples in which the VCSEL array projects a regular (e.g., grid) pattern of light. The regular pattern represents a repeated (e.g., consistent) pattern of light emitting elements. In some cases, the regular pattern includes columns and rows of light emitting elements that are arranged generally perpendicularly relative to one another (see FIG. 2). For example, the array of light emitting devices 22 can be arranged as a grid (e.g., a 12x9 grid) of light emitting devices. In some cases, the regular pattern of light can include an angled (e.g., slanted) regular pattern. Thus, in some implementations, the regular pattern includes columns and rows of light emitting elements in which rows are angled (e.g., non-perpendicular or offset) with respect to the direction of columns (see FIG. 3).

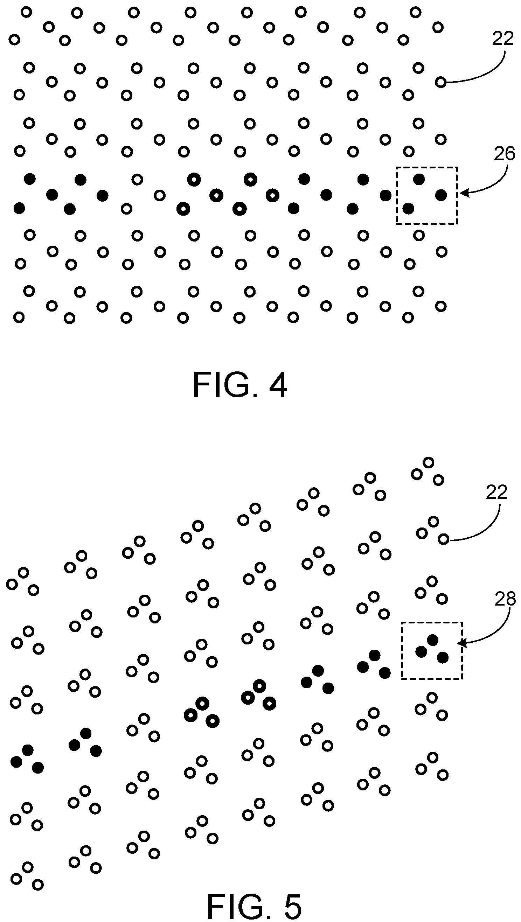

FIGS. 4 and 5 depict examples in which the VCSEL array projects a regular pattern of a sub pattern 26 or 28 of lights (e.g., a grid of smaller clusters of light). In some cases, the regular pattern includes columns and rows of clusters 26 (or 28) of light emitting elements 22, where the clusters are arranged generally perpendicularly relative to one another (see FIG. 4). In some cases, the regular pattern of light can include an angled (e.g., slanted) regular pattern of clusters 28 (see FIG. 5). Thus, in some implementations, the regular pattern includes columns and rows of clusters 28 of light emitting elements 22 in which rows of clusters 28 are angled (e.g., non- perpendicular) with respect to the direction of columns.

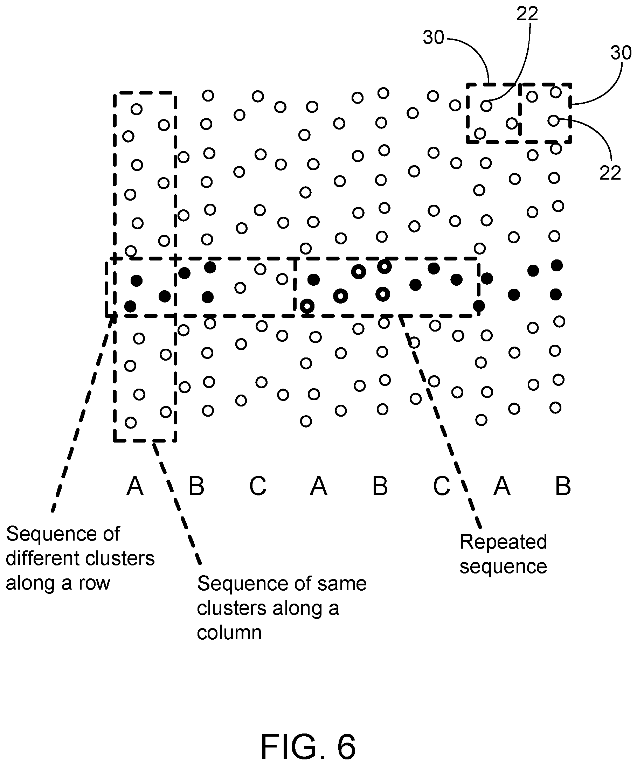

FIG. 6 depicts another example in which the VCSEL array projects a regular pattern of a sub pattern of lights (e.g., a grid of smaller clusters of light) that have commonly shaped clusters 30 in one direction of the grid (e.g., along columns or the y-axis) and differently shaped clusters in a different direction of the grid (e.g., along rows or the x-axis). In some cases, as depicted, the grid has a sequence of differently shaped clusters from column to column (e.g., marked A, B, and C in FIG. 6). In some implementations, the sequence of differently shaped clusters along a row is repeated (e.g., A, B, C, A, B, C, etc.).

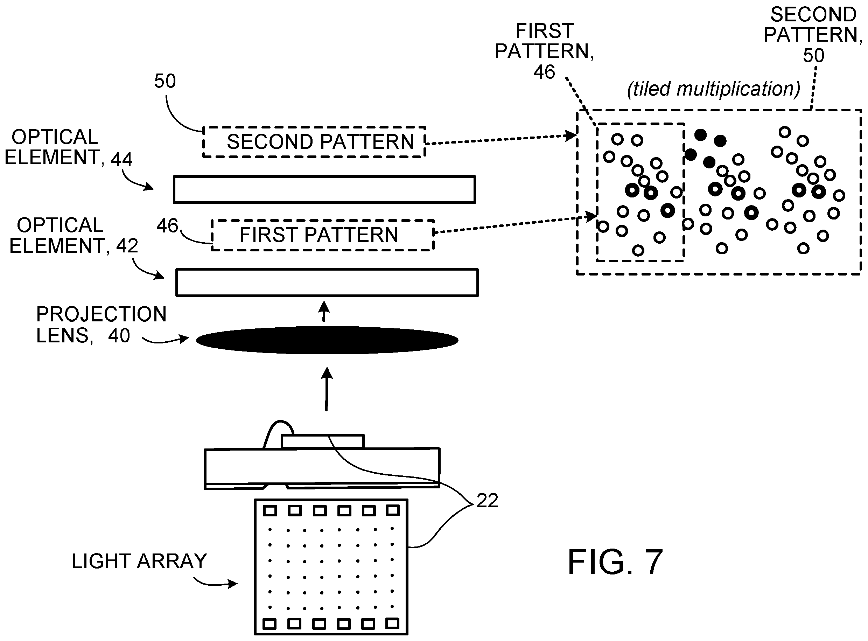

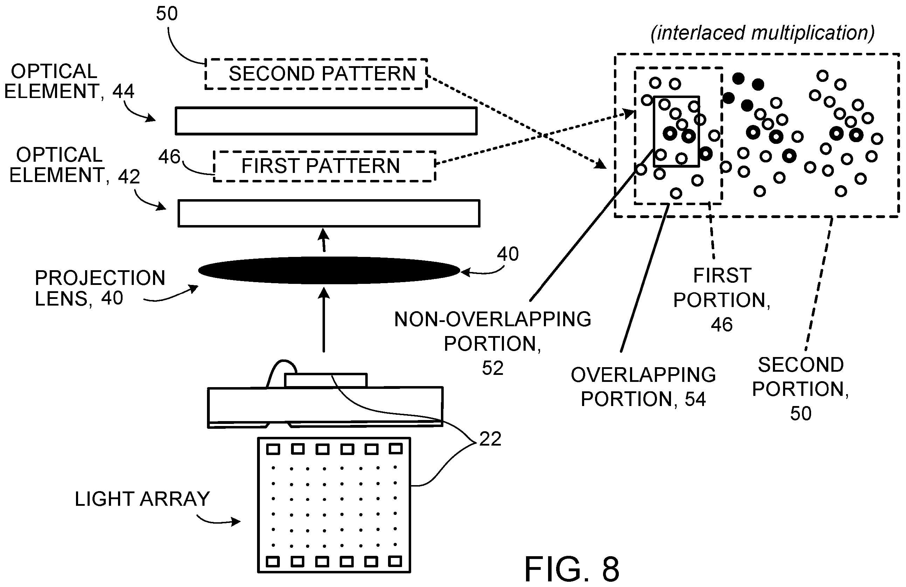

The system 20 of FIG. 1 also includes a projection lens system 40 and first and second optical elements 42, 44. As illustrated by FIGS. 7 and 8, the projection lens system 40 is configured to receive light emitted from the array of VCSELs 22 and to project the light to the first optical element 42. The first optical element 42 is configured to alter the pattern of light emitted by the array of VCSELs 22 to generate a first emitted irregular pattern 46 of light. The irregular pattern 46 can be, for example, a randomized, non-uniform, non-grid, disrupted, unevenly spaced, partially obstructed, partially blocked, and/or non-equally distributed pattern. The second optical element 44 is configured to receive the irregular pattern 46 of light generated by the first optical element 42 and to reproduce the first emitted pattern in a second emitted pattern 50 that comprises multiple instances of the first emitted pattern 46 arranged, for example, in a tiled pattern (see FIG. 7). The second optical element 44 can reproduce the first emitted pattern 46, for example, by tiling, distributing and/or duplicating the first emitted pattern. The pattern 50 produced by the second optical element 44 can be, for example, a regular or uniformly distributed pattern of multiple instances of the first pattern 46. Thus, in some implementations, the pattern of light emitted collectively from the light emitting devices 22 is a uniformly distributed pattern of light, the first emitted pattern 46 is an irregular pattern, and the second emitted pattern 50 is a uniform distribution of the irregular pattern.

In some implementations, the tiled pattern 50 comprises adjacent instances of the first emitted pattern 46 separated from one another. In some implementations, the tiled pattern 50 comprises multiple instances of the first emitted pattern 46 arranged in a series of columns and rows. In some cases, the arrangement comprises a matrix, such as a 3x3 matrix or a 2 by 2 matrix.

In some implementations, the second emitted pattern 50 comprises multiple interlaced, or at least partially overlapping, instances of the first emitted pattern 46 (see FIG. 8). In some cases, the overlapping patterns include at least one element of a first pattern instance being disposed within or between multiple elements of a second pattern instance. In some implementations, despite adjacent instances at least partially overlapping with one another, at least some portions of the individual instances (e.g., a central region, a majority portion, or a majority portion of a central region) can be unobstructed by an adjacent instance. That is, in some cases, adjacent instances (e.g., tiles) can partially overlap one another, yet remain substantially distinct (e.g., unaltered) by surrounding tiles. In some cases, each of the overlapping tiles is at least 20% non-overlapping or in some cases, even more (e.g., at least 30%, 40%, 50%, 60%, 70%, 80%, 90% or 95%), where the non-overlapping portions of the tiles are representative of the pattern of light provided to the second optical element (i.e., the first pattern). As depicted in FIG. 8, the interlaced tiles can include a central non-overlapping portion 52 and an outer overlapping portion (e.g., an overlapping border) 54 that overlaps with an outer overlapping portion of an adjacent tile.

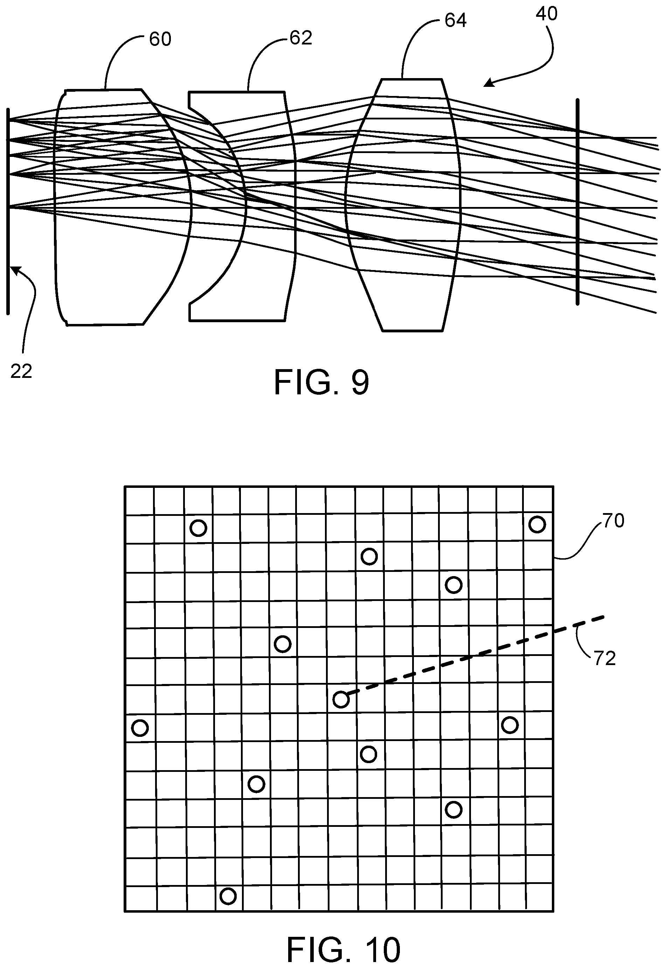

FIG. 9 depicts an example of the projection lens system 40, which can include one or more optical components arranged to project light from the light emitting elements 22. Various configurations of the optical components are possible. For example, the projection lens 40 can include one or more lens elements 60, 62, 64 arranged linearly, and which may be formed by any suitable manufacturing technique (e.g., injection molding or wafer-level manufacturing techniques). The specific optical properties of the projection lens system 40 can be adapted for specific applications. In some implementations, the projection lens system 40 has an effective focal length that is less than or equal to about 5 millimeters (mm) (e.g., in the range of 1.5 mm - 5 mm). In some cases, the projection lens has an object field height that is less than or equal to about 1 mm (e.g., in the range of 0.2 mm - 1.0 mm). Additionally, specific configurations of lens types can be adapted for particular applications. In some implementations, at least one lens element is telecentric on an object side of the projection lens system 40, with no system aperture. However, in some implementations, the projection lens system 40 includes non-telecentric lens designs (e.g., chief ray angle (CRA) <> 0 deg) and uses one or more system apertures.

The optical elements 42, 44 can be implemented, for example, as respective diffractive optical elements, which are operable to create the desired patterns of light from the light produced by the regular array of light emitting elements 22. In some implementations, one or both of the diffractive optical elements 42, 44 includes a respective diffraction grating (e.g., a two-dimensional grating) 70 that splits an incoming beam 72 (see FIG. 10). For example, an incoming beam entering the diffractive optical element 42 may be emitted from a single light emitting element (e.g., VCSEL) after having been collimated by the projection lens system 40.

The diffractive optical elements 42, 44 can be formed in any suitable constructions. For example, in some cases, the diffractive optical element is formed as a binary transmission mask. In some instances, the diffractive optical element is formed as a phase element, which can include a surface relief profile with discrete levels, a continuous profile or any other optical microstructure that imposes an appropriate phase shift on the incoming wave. If the unit cell of the diffractive grating contains n x n pixels with N different phase levels (where N is an uneven number), a grid of n x n diffraction orders can be created. In the example of FIG. 10, which has 15x15 orders, twelve diffraction orders are chosen on randomly chosen positions in the grid. The diffractive optical element is configured (e.g., optimized) to illuminate only the desired diffraction orders. As a result, an irregular optical pattern can be produced.

As noted above, details of the various components of the system 20 can vary depending on the particular implementation. However, a particular implementation is operable to produce coded, structured light based on tiled, toroidal perfect sub-maps. In this case, the projected pattern can consist, for example, of repeating tiles, each of which is a two-dimensional toroidal perfect sub-map. Each dot in the pattern projected by the system is isolated and surrounded by zeros (i.e., no immediately adjacent dot of light). The pattern can have a very high level of randomness. Further, using a regular array, for example, of several hundred (e.g., 600) VCSELs, the projected pattern can have tens of thousands (e.g., 39,000) of dots, wherein at least about 75% of the dots are within the camera's field of view. The VCSEL array can have translational symmetry in the y-direction (or the x-direction). Further, some of the VCSELs may emit a wavelength (i.e., color) of light that differs from the wavelength emitted by other VCSELs in the array. The first diffractive element creates an uncorrected dot pattern for the laser beams, and the second diffractive element multiplies the uncorrected dot pattern into a matrix **(e.g.,** 3x3) pattern. The divergence angles and fan-out angles can be optimized to project copies of the uncorrected dot pattern are separated from one another by relatively large gaps. The final pattern projected by the system is, in some cases, color coded and uniform.

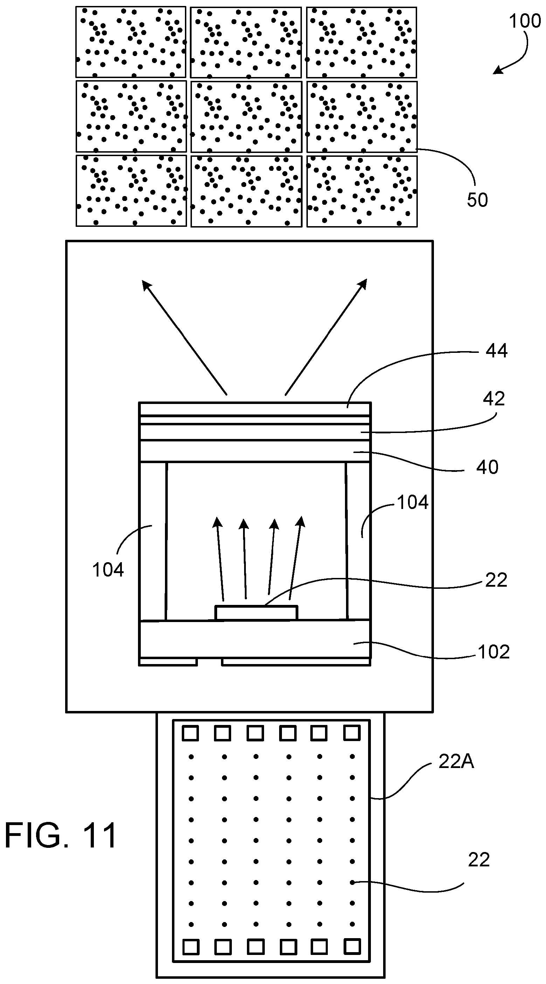

As illustrated in FIG. 11, the structured light projection system (including the regular array of VCSELs or other light emitting elements 22, the projection lens system 40 and the diffractive optical elements 42, 44) can be integrated as part of a module 100. The VCSELs 22 can be mounted over a printed circuit board or other substrate 102 that is separated from the optical components (e.g., 40, 42, 44) by a spacer 104 that establishes a well-defined distance between the VCSELs 22 and the projection lens system 40. The spacer 104 laterally surrounds the VCSELs 22 and serves as sidewalls for the module. In some cases, the module is compact with a relatively small footprint and small z-height.

The systems and methods described above for creating and projecting structured light can be used, for example, in association with various imaging systems, such as three-dimensional imaging and video systems. Further, structured light projection systems as described above, or modules incorporating such structured light projection systems, can be integrated into a wide range of host devices such as smartphones, laptops, wearable devices and other computing devices that may have with networking capability. The host devices may include processors and other electronic components, and other supplemental modules configured to collect data, such as cameras, time-of-flight imagers. Other supplemental modules may be included such as ambient lighting, display screens, automotive headlamps, and the like. The host devices may further include non-volatile memory where instructions for operating the optoelectronic modules, and in some instances the supplemental modules, are stored.

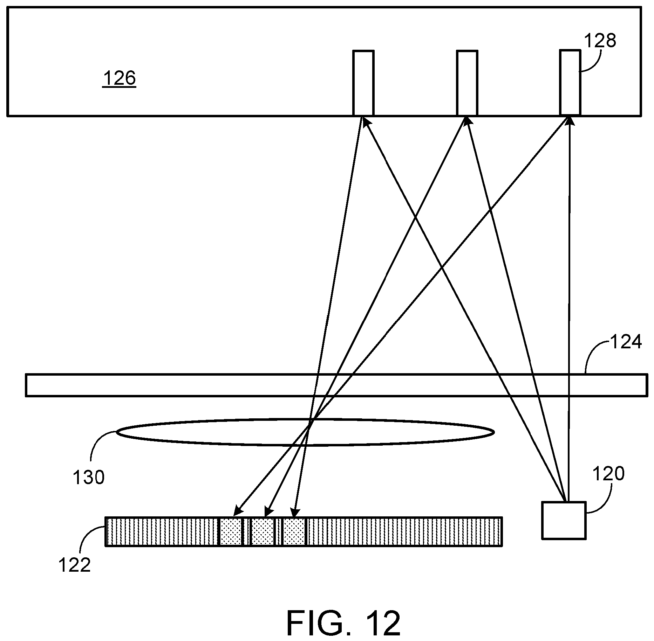

FIG. 12 illustrates an example of an optoelectronic system includes a structured light projector 20 as described above and operable to project a structured light pattern 128 onto one or more objects in a scene 126 of interest. In some implementations, the projected pattern consists of light in the IR or near-IR region of the spectrum. Light from the projected pattern 128 can be reflected by the object(s) in the scene 126 and sensed by an image sensor 122 that includes spatially distributed light sensitive components (e.g., pixels) that are sensitive to a wavelength of light emitted by the light projector 20. In some cases, one or more optical elements such as lenses 130 help direct the light reflected from the scene 126 toward the image sensor 122. The detected signals can be read-out and used, for example, by processing circuitry for stereo matching to generate a three-dimensional image. The processing circuitry can be operable to determine a physical characteristic of the object based at least in part on a signal from the sensor, and/or to use data obtained by the optical sensor for one or more functions executed by the host device. Using structured light can be advantageous, for example, in providing additional texture for matching pixels in the stereo images.

In some implementations, the light projector 20, the lenses 128 and the image sensor 122 are integrated within a host computing device (e.g., a smartphone). In such cases, the light projector 20, the lenses 28 and the image sensor 22 can be disposed below a front side cover glass 124 of the host device. The structured light emitted by the light projector 20 can result in a pattern 128 of discrete features (i.e., texture or encoded light) being projected onto objects in the scene 126 external to the host device. In some instances, the light projector 20, the lenses 128 and the image sensor 122 are components of the same optoelectronic module. In other implementations, the light projector 20 can be a discrete component that is not integrated into the same module as the image sensor 122 and/or lens 128. Further, the light projector 210 can be used in other types of applications (e.g., proximity sensing, distance determinations using triangulation) as well and is not limited to the imaging applications referred to above.

Modules incorporating a structured light projection system as described above can, in some instances, obtain more accurate data than other techniques. Thus, functions performed by the host device based on signals emitted from the structured light projection system can be performed more accurately, thereby conferring substantial advantages to the smartphone or other host device.

Although a broad framework of the disclosure is described with reference to various preferred embodiments, other implementations may include combinations and subcombinations of elements described in this disclosure. For example, features described in connection with different implementations above may, in some cases, be combined in the same implementation.

## Claims

1. A method of projecting an irregular structured light pattern (50) onto an object, the irregular structured light pattern (50) being created from a regular array of light emitting elements (22), the method comprising:
generating a regular pattern of light from a uniformly distributed array of light emitting elements (22);
altering the regular pattern of light to generate an irregular pattern of light (46);
reproducing the irregular pattern of light (46) in multiple instances arranged adjacent one another; and projecting the multiple instances of the irregular pattern of light (46) onto the object;
**characterized in that**:
altering the regular pattern of light comprises illuminating randomly selected diffraction orders of a diffractive optical element (42, 44).

2. The method of Claim 1 wherein the array of light emitting elements (22) includes columns and rows of light emitting elements (22), wherein the rows are either:
arranged perpendicularly relative to the columns; or angled relative to the columns.

3. The method of Claim 1 wherein the array of light emitting elements (22) produces a regular pattern of a sub pattern of lights (26, 28).

4. The method of Claim 1 wherein the array of light emitting elements (22) produces a grid of a cluster of lights (30), wherein the grid has commonly shaped Clusters (30) in a first direction, and wherein the grid has differently shaped Clusters (30) in a second direction perpendicular to the first direction.

5. The method of any one of the preceding Claims further including receiving light emitted from the array of light emitting elements (22) and projecting the light to a first diffractive optical element (42) to generate the irregular pattern of light (46).

6. The method of Claim 1 wherein the irregular pattern of light (46) is at least one of a randomized, non-uniform, non-grid, disrupted, unevenly spaced, partially obstructed, partially blocked, and/or non-equally distributed pattern.

7. The method of Claim 1 wherein reproducing the irregular pattern of light (46) includes producing one of:
a tiled pattern; or
a uniform distribution of the irregular pattern of light (46); or
multiple interlaced instances of the irregular pattern of light (46); or
multiple partially overlapping instances of the irregular pattern of light (46).

8. A structured light projection system (20) comprising:
an array of light emitting elements (22) operable, collectively, to emit a regular pattern of light;
a first optical element (42) configured to alter the pattern of light emitted by the array of light emitting elements to generate a first irregular pattern of light (46); and
a second optical element (44) configured to receive the irregular pattern of light (46) generated by the first optical element (42) and to produce a pattern (50) comprising multiple instances of the first irregular pattern (46), wherein the structured light projection System (20) is configured to project the multiple instances of the first irregular pattern (46) onto an object;
**characterized in that**:
the first optical element is a diffractive optical element configured such that altering the pattern of light emitted by the array of light emitting elements (22) comprises illuminating randomly selected diffraction orders of the diffractive optical element (42).

9. The structured light projection System (20) of Claim 8 wherein the array of light emitting elements (22) includes columns and rows of light emitting elements (22), wherein the rows are either:
arranged perpendicularly relative to the columns; or angled relative to the columns.

10. The structured light projection System (20) of Claim 8 wherein the array of light emitting elements (22) is operable to project a regular pattern of a sub pattern of lights (26, 28).

11. The structured light projection System (20) of Claim 8 wherein the array of light emitting elements (22) is operable to project a grid of a cluster of lights (30), wherein the grid has commonly shaped Clusters (30) in a first direction, and wherein the grid has differently shaped Clusters (30) in a second direction perpendicular to the first direction.

12. The structured light projection System (20) of any one of Claims 8 to 11 further including
a projection lens System (40) operable to receive light emitted from the array of light emitting elements (22) and to project the light to the first optical element (42).

13. The structured light projection System (20) of Claim 8 wherein the first irregular pattern of light (46) is at least one of a randomized, non-uniform, non-grid, disrupted, unevenly spaced, partially obstructed, partially blocked, and/or non-equally distributed pattern.

14. The structured light projection System (20) of Claim 8 wherein the second optical element (44) is arranged to produce one of:
a tiled pattern; or
a uniform distribution of the irregular pattern of light (46); or
multiple interlaced instances of the irregular pattern of light (46); or
multiple partially overlapping instances of the irregular pattern of light (46).

15. The structured light projection System (20) of Claim 8 wherein each of the first (42) and second (44) optical elements comprises a diffractive optical element.

## Patentansprüche

1. Verfahren zum Projizieren eines unregelmäßig strukturierten Lichtmusters (50) auf ein Objekt, wobei das unregelmäßig strukturierte Lichtmuster (50) aus einer regelmäßigen Anordnung von lichtemittierenden Elementen (22) erzeugt wird, das Verfahren aufweisend:
Erzeugen eines regelmäßigen Musters aus Licht aus einer gleichmäßig verteilten Anordnung von lichtemittierenden Elementen (22);
Verändern des regelmäßigen Musters aus Licht, um ein unregelmäßiges Muster aus Licht (46) zu erzeugen;
Reproduzieren des unregelmäßigen Musters aus Licht (46) in mehreren Instanzen, die nebeneinander angeordnet sind;
und
Projizieren der mehreren Instanzen des unregelmäßigen Musters aus Licht (46) auf das Objekt;
**dadurch gekennzeichnet, dass**:
das Verändern des regelmäßigen Musters aus Licht das Beleuchten zufällig ausgewählter Beugungsordnungen eines diffraktiven optischen Elements (42, 44) aufweist.

2. Verfahren nach Anspruch 1, wobei die Anordnung von lichtemittierenden Elementen (22) Spalten und Zeilen von lichtemittierenden Elementen (22) aufweist, wobei die Zeilen entweder:
senkrecht zu den Spalten angeordnet sind; oder
in einem Winkel zu den Spalten angeordnet sind.

3. Verfahren nach Anspruch 1, wobei die Anordnung von lichtemittierenden Elementen (22) ein regelmäßiges Muster eines Teilmusters von Lichtern (26, 28) erzeugt.

4. Verfahren nach Anspruch 1, wobei die Anordnung von lichtemittierenden Elementen (22) ein Raster aus einer Gruppe von Lichtern (30) erzeugt, wobei das Raster in einer ersten Richtung gleichförmige Gruppen (30) aufweist und wobei das Raster in einer zweiten Richtung senkrecht zur ersten Richtung unterschiedlich geformte Gruppen (30) aufweist.

5. Verfahren nach einem der vorstehenden Ansprüche, ferner aufweisend das Empfangen von Licht, das von der Anordnung von lichtemittierenden Elementen (22) emittiert wird, und das Projizieren des Lichts auf ein erstes diffraktives optisches Element (42), um das unregelmäßige Lichtmuster (46) zu erzeugen.

6. Verfahren nach Anspruch 1, wobei das unregelmäßige Lichtmuster (46) mindestens eines von folgenden Mustern ist: zufällig, ungleichmäßig, nicht-rasterförmig, unterbrochen, ungleichmäßig beabstandet, teilweise verdeckt, teilweise blockiert und/oder ungleichmäßig verteilt.

7. Verfahren nach Anspruch 1, wobei das Reproduzieren des unregelmäßigen Musters aus Licht (46) das Erzeugen eines der folgenden aufweist:
ein gekacheltes Muster; oder
eine gleichmäßige Verteilung des unregelmäßigen Musters aus Licht (46); oder
mehrere ineinander verschachtelte Instanzen des unregelmäßigen Musters aus Licht (46); oder
mehrere sich teilweise überlappende Instanzen des unregelmäßigen Musters aus Licht (46).

8. Strukturiertes Lichtprojektionssystem (20), aufweisend:
eine Anordnung von lichtemittierenden Elementen (22), die gemeinsam betreibar sind, um ein regelmäßiges Muster aus Licht zu emittieren;
ein erstes optisches Element (42), das eingerichtet ist, das von der Anordnung von lichtemittierenden Elementen emittierte Muster aus Licht zu verändern, um ein erstes unregelmäßiges Muster aus Licht (46) zu erzeugen; und
ein zweites optisches Element (44), das eingerichtet ist, das vom ersten optischen Element (42) erzeugte unregelmäßige Muster aus Licht (46) zu empfangen und ein Muster (50) zu erzeugen, das mehrere Instanzen des ersten unregelmäßigen Musters (46) aufweist, wobei das strukturierte Lichtprojektionssystem (20) eingerichtet ist, die mehreren Instanzen des ersten unregelmäßigen Musters (46) auf ein Objekt zu projizieren;
**dadurch gekennzeichnet, dass**:
das erste optische Element ein diffraktives optisches Element ist, das eingerichtet ist, das Ändern des Musters aus Licht, das von der Anordnung von lichtemittierenden Elementen (22) emittiert wird, ein Beleuchten zufällig ausgewählter Beugungsordnungen des diffraktiven optischen Elements (42) aufweist.

9. Strukturiertes Lichtprojektionssystem (20) nach Anspruch 8, wobei die Anordnung von lichtemittierenden Elementen (22) Spalten und Zeilen von lichtemittierenden Elementen (22) aufweist, wobei die Zeilen entweder:
senkrecht zu den Spalten angeordnet sind; oder
in einem Winkel zu den Spalten angeordnet sind.

10. Strukturiertes Lichtprojektionssystem (20) nach Anspruch 8, wobei die Anordnung von lichtemittierenden Elementen (22) betreibbar ist, ein regelmäßiges Muster eines Teilmusters von Lichtern (26, 28) zu projizieren.

11. Strukturiertes Lichtprojektionssystem (20) nach Anspruch 8, wobei die Anordnung von lichtemittierenden Elementen (22) betreibbar ist, ein Raster aus einer Gruppe von Lichtern (30) zu projizieren, wobei das Raster in einer ersten Richtung gleichförmige Gruppen (30) aufweist und wobei das Raster in einer zweiten Richtung senkrecht zur ersten Richtung unterschiedlich geformte Gruppen (30) aufweist.

12. Strukturiertes Lichtprojektionssystem (20) nach einem der Ansprüche 8 bis 11, ferner aufweisend ein Projektionslinsensystem (40), das betreibbar ist, dass von der Anordnung von lichtemittierenden Elementen (22) emittierte Licht zu empfangen und das Licht auf das erste optische Element (42) zu projizieren.

13. Strukturiertes Lichtprojektionssystem (20) nach Anspruch 8, wobei das erste unregelmäßige Muster aus Licht (46) mindestens eines von folgenden Mustern ist: zufällig, ungleichmäßig, nicht-rasterförmig, unterbrochen, ungleichmäßig beabstandet, teilweise verdeckt, teilweise blockiert und/oder ungleichmäßig verteilt.

14. Strukturiertes Lichtprojektionssystem (20) nach Anspruch 8, wobei das zweite optische Element (44) so angeordnet ist, dass es eines der folgenden erzeugt:
ein gekacheltes Muster; oder
eine gleichmäßige Verteilung des unregelmäßigen Musters aus Licht (46); oder
mehrere ineinander verschachtelte Instanzen des unregelmäßigen Musters aus Licht (46); oder
mehrere sich teilweise überlappende Instanzen des unregelmäßigen Musters aus Licht (46).

15. Strukturiertes Lichtprojektionssystem (20) nach Anspruch 8, wobei jedes der ersten (42) und zweiten (44) optischen Elemente ein diffraktives optisches Element aufweist.

## Revendications

1. Procédé de projection d'un motif irrégulier de lumière structurée (50) sur un objet, le motif irrégulier de lumière structurée (50) étant créé à partir d'un réseau régulier d'éléments électroluminescents (22), le procédé comprenant :
la génération d'un motif régulier de lumière à partir d'un réseau uniformément réparti d'éléments électroluminescents (22) ;
la modification du motif régulier de lumière pour générer un motif de lumière irrégulier (46) ;
la reproduction du motif irrégulier de lumière (46) en plusieurs instances disposées de manière adjacente les unes aux autres ; et
la projection des plusieurs instances du motif irrégulier de lumière (46) sur l'objet ;
**caractérisé en ce que** :
la modification du motif régulier de lumière comprend l'illumination d'ordres de diffraction sélectionnés de manière aléatoire d'un élément optique diffractif (42, 44).

2. Procédé selon la revendication 1, dans lequel le réseau d'éléments électroluminescents (22) comprend des colonnes et des rangées d'éléments électroluminescents (22), les rangées étant soit :
disposées perpendiculairement par rapport aux colonnes ; soit
inclinées par rapport aux colonnes.

3. Procédé selon la revendication 1, dans lequel le réseau d'éléments électroluminescents (22) produit un motif régulier d'un sous-motif de lumières (26, 28).

4. Procédé selon la revendication 1, dans lequel le réseau d'éléments électroluminescents (22) produit une grille d'un groupe de lumières (30), dans lequel la grille comporte des groupes (30) de forme commune dans une première direction, et dans lequel la grille comporte des groupes (30) de forme différente dans une deuxième direction perpendiculaire à la première direction.

5. Procédé selon l'une quelconque des revendications précédentes, comprenant en outre la réception de la lumière émise depuis le réseau d'éléments électroluminescents (22) et la projection de la lumière vers un premier élément optique diffractif (42) afin de générer le motif irrégulier de lumière (46).

6. Procédé selon la revendication 1, dans lequel le motif irrégulier de lumière (46) est au moins l'un parmi un motif aléatoire, non uniforme, non quadrillé, perturbé, espacé de manière inégale, partiellement obstrué, partiellement bloqué et/ou non uniformément distribué.

7. Procédé selon la revendication 1, dans lequel la reproduction du motif irrégulier de lumière (46) comprend la production de l'un parmi :
un motif en mosaïque ; ou
une distribution uniforme du motif irrégulier de lumière (46) ; ou
plusieurs instances entrelacées du motif irrégulier de lumière (46) ; ou
plusieurs instances partiellement superposées du motif irrégulier de lumière (46).

8. Système de projection de lumière structurée (20), comprenant :
un réseau d'éléments électroluminescents (22) pouvant fonctionner collectivement pour émettre un motif régulier de lumière ; un premier élément optique (42) configuré pour modifier le motif de lumière émis par le réseau d'éléments électroluminescents afin de générer un premier motif irrégulier de lumière (46), et
un deuxième élément optique (44) configuré pour recevoir le motif irrégulier de lumière (46) généré par le premier élément optique (42) et pour produire un motif (50) comprenant plusieurs instances du premier motif irrégulier (46), dans lequel le système de projection de lumière structurée (20) est configuré pour projeter les plusieurs instances du premier motif irrégulier (46) sur un objet ;
**caractérisé en ce que** :
le premier élément optique est un élément optique diffractif configuré de telle sorte que la modification du motif de lumière émis par le réseau d'éléments électroluminescents (22) comprend l'illumination d'ordres de diffraction sélectionnés de manière aléatoire de l'élément optique diffractif (42).

9. Système de projection de lumière structurée (20) selon la revendication 8, dans lequel le réseau d'éléments électroluminescents (22) comprend des colonnes et des rangées d'éléments électroluminescents (22), dans lequel les rangées sont soit :
disposées perpendiculairement par rapport aux colonnes ; soit
inclinées par rapport aux colonnes.

10. Système de projection de lumière structurée (20) selon la revendication 8, dans lequel le réseau d'éléments électroluminescents (22) peut fonctionner pour projeter un motif régulier d'un sous-motif de lumières (26, 28).

11. Système de projection de lumière structurée (20) selon la revendication 8, dans lequel le réseau d'éléments électroluminescents (22) peut fonctionner pour projeter une grille d'un groupe de lumières (30), dans lequel la grille comporte des groupes (30) de forme commune dans une première direction, et dans lequel la grille comporte des groupes (30) de forme différente dans une deuxième direction perpendiculaire à la première direction.

12. Système de projection de lumière structurée (20) selon l'une quelconque des revendications 8 à 11, comprenant en outre
un système de lentilles de projection (40) pouvant fonctionner pour recevoir la lumière émise depuis le réseau d'éléments électroluminescents (22) et pour projeter la lumière vers le premier élément optique (42).

13. Système de projection de lumière structurée (20) selon la revendication 8, dans lequel le premier motif irrégulier de lumière (46) est au moins l'un parmi un motif aléatoire, non uniforme, non quadrillé, perturbé, espacé de manière inégale, partiellement obstrué, partiellement bloqué et/ou non uniformément distribué.

14. Système de projection de lumière structurée (20) selon la revendication 8, dans lequel le deuxième élément optique (44) est agencé pour produire l'un parmi :
un motif en mosaïque ; ou
une distribution uniforme du motif irrégulier de lumière (46) ; ou
plusieurs instances entrelacées du motif irrégulier de lumière (46) ; ou
plusieurs instances se chevauchant partiellement du motif irrégulier de lumière (46).

15. Système de projection de lumière structurée (20) selon la revendication 8, dans lequel chacun des premier (42) et deuxième (44) éléments optiques comprend un élément optique diffractif.
